Europäisches Patentamt

European Patent Office

Office européen des brevets

(11) Numéro de publication: **0 286 664 B1**

# FASCICULE DE BREVET EUROPEEN

(45) Date de publication de fascicule du brevet: **26.05.93**   (51) Int. Cl.⁵: **G01R 25/00**, H03H 9/64

(21) Numéro de dépôt: **87906674.4**

(22) Date de dépôt: **06.10.87**

(86) Numéro de dépôt internationale :
**PCT/FR87/00383**

(87) Numéro de publication internationale :
**WO 88/02867 (21.04.88 88/09)**

(54) **DISPOSITIF DE MESURE DE PHASE ET PROCEDE METTANT EN OEUVRE UN FILTRE.**

(30) Priorité: **07.10.86 FR 8613938**

(43) Date de publication de la demande:
**19.10.88 Bulletin 88/42**

(45) Mention de la délivrance du brevet:
**26.05.93 Bulletin 93/21**

(84) Etats contractants désignés:
**DE GB IT NL**

(56) Documents cités:
**EP-A- 0 128 804**

**Nachrichten Elektronik, vol. 32, no. 6, juin 1978; G. Kohlbacher et al.: "Bauelemente mit akustischen Oberflächenwellen", pages 181-187**

(73) Titulaire: **THOMSON-CSF**
**51, Esplanade du Général de Gaulle**
**F-92800 Puteaux(FR)**

(72) Inventeur: **FOUCHE, Yvon**
**48, rue Roger-Salengro**
**F-92290 Châtenay-Malabry(FR)**
Inventeur: **ELLEAUME, Philippe**
**49, rue de Châtenay**
**F-92160 Antony(FR)**
Inventeur: **DRABOWITCH, Serge**
**8, rue des Prés-Hauts**
**F-92290 Châtenay-Malabry(FR)**

(74) Mandataire: **Benoit, Monique et al**
**THOMSON-CSF, SCPI, B.P. 329, 50, rue Jean-Pierre Timbaud**
**F-92402 Courbevoie Cédex (FR)**

## Description

La présente invention concerne un procédé et un dispositif de mesure de phase.

Pour effectuer des mesures sur un signal radioélectrique il est avantageux de faire passer ledit signal dans un filtre adapté pour augmenter son amplitude. Toutefois si la quantité à mesurer varie avec le temps la mesure risque de tenir compte de deux valeurs successives de ladite quantité. Ainsi il est primordial d'effectuer la mesure au moment où le signal, à la sortie du filtre adapté n'est influencé que par une seule valeur de la quantité à mesurer.

Le dispositif selon la présente invention permet notamment d'effectuer des mesures de phase d'un signal continu.

La présente invention a principalement pour objet un dispositif de mesure de phase susceptible de mesurer la phase d'un signal en sortie d'un filtre adapté, caractérisé en ce qu'il comporte :
- un filtre dont l'entrée est connectée en parallèle à l'entrée du filtre adapté, ledit filtre étant impair, c'est-à-dire ayant une fonction de transfert symétrique en amplitude et antisymétrique en phase par rapport à la fréquence centrale dudit filtre ;
- un détecteur de passage à 0 du signal issu du filtre impair ; et
- des moyens de mesure de phase commandés par le détecteur et effectuant une comparaison de la phase du signal issu du filtre adapté avec une phase de référence.

Le filtre impair peut être par exemple un filtre à onde de surface dont le principe et la mise en oeuvre sont décrits de manière très générale dans le document nachrichten elektronik 6–1978, Vol. 32, n° 6 Juin 1978, pages 181–187 : "Bauelemente mit akustischen Oberflächenwellen" de G. KOHLBACHER et al.

La présente invention a aussi pour objet un procédé de mesure de phase tel que décrit dans la revendication 11.

La présente invention sera mieux comprise au moyen de la description ci–après et des figures annexées données comme des exemples non limitatifs parmi lesquels :
- la figure 1 est un schéma illustrant l'enveloppe d'un signal ;
- la figure 2 est un schéma illustrant l'enveloppe du signal de la figure 1 après son passage dans un filtre adapté ;
- la figure 3 est un schéma illustrant l'enveloppe d'un signal ;
- la figure 4 est un schéma illustrant les limites de variation de l'enveloppe du signal de la figure 3 après son passage dans le filtre adapté;
- la figure 5 est un exemple de l'enveloppe du signal de la figure 3 après le passage dans un filtre adapté ;
- la figure 6 est un schéma montrant la phase d'un signal après le passage dans un filtre impair ;
- la figure 7 est un schéma d'une première variante de réalisation du dispositif selon l'invention ;
- la figure 8 est un schéma d'une seconde variante du dispositif selon l'invention ;
- la figure 9 est un schéma d'une troisième variante de réalisation du dispositif selon l'invention ;
- la figure 10 est un schéma d'une quatrième variante de réalisation du dispositif selon l'invention.

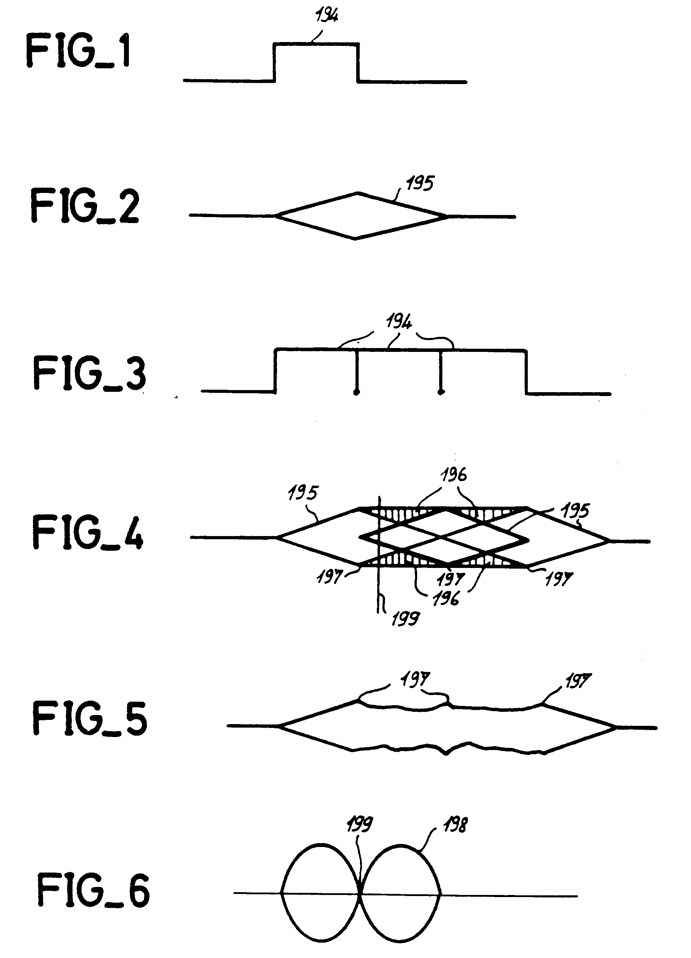

Sur les figures 1 à 10 on a utilisé les mêmes références pour désigner les mêmes éléments.

Pour la clarté des figures 1 à 6 on n'y a pas représenté les porteuses.

Sur la figure 1, on peut voir l'enveloppe d'un signal carré 194. Dans l'exemple illustré, le signal 194 est un signal cohérent d'amplitude et de phase constante.

Sur la figure 2, on peut voir l'enveloppe 195 du signal 194 de la figure 1 après son passage dans un filtre adapté. La phase du signal à la sortie du filtre adapté est la même que celle du signal 194. Ainsi, si l'on désire mesurer cette phase cette mesure peut être effectuée à tout moment. Avantageusement on effectue la mesure de phase lorsque l'amplitude du signal à la sortie du filtre adapté est maximale.

Sur la figure 3, on peut voir un chronogramme comportant trois signaux 194 successifs. Le signal est par exemple un signal cohérent d'amplitude constante. Chaque échantillon 194 du signal comporte sa propre phase provenant par exemple des transmissions d'information en modulation de phase.

Sur la figure 4, on peut voir la valeur que peut prendre la valeur du signal de la figure 3 ayant traversé un filtre adapté à un échantillon 194 du signal. Les trois losanges 195 correspondent au signal que l'on obtiendrait en faisant passer par le filtre adapté individuellement chaque échantillon 194 du signal. L'enveloppe totale du signal comporte la moitié du premier losange 195, est incluse dans le triangle hachuré 196, passe par le point 197 dont la valeur correspond à celle des losanges 195, est incluse dans le triangle hachuré 196 et se termine par la fin du dernier losange 195. Si l'on effectue la mesure de la phase du signal présent à la sortie du filtre adapté, sans prendre de précautions particulières on risque de mesurer la valeur de la somme de phase de deux échantillons 195 successifs du signal. Par exemple, si on effectue la mesure de phase à l'instant correspondant à la référence 199 sur la figure 4, on mesurera une phase qui correspondra à

$$\frac{3\varphi_1 + \varphi_2}{4},$$

$\phi_1$ étant la phase du premier échantillon 194 du signal, $\phi_2$ la phase du second échantillon 194 du signal.

Sur la figure 5, on peut voir un exemple d'enveloppe d'un signal ayant traversé un filtre adapté à l'échantillon du signal. Comme on peut voir sur les figures 4 et 5, une mesure de phase faite au temps correspondant au point 197 permet de mesurer la phase pure correspondant à un seul échantillon du signal 194.

Sur la figure 6, on peut voir l'enveloppe du signal 198 ayant traversé un filtre impair. On voit que le signal s'annule au point 199.

La présente invention utilise ce phénomène pour déterminer le point 197 permettant la mesure de phase correspondant à un seul échantillon 194 du signal. Le filtre impair est par exemple un filtre à onde de surface (SAW en terminologie anglosaxonne) ou un filtre numérique.

Un filtre impair, ou asymétrique est un filtre dont la fonction de transfert est impaire pour la phase, par rapport à la fréquence centrale du filtre et est symétrique pour l'amplitude par rapport à la fréquence centrale dudit filtre.

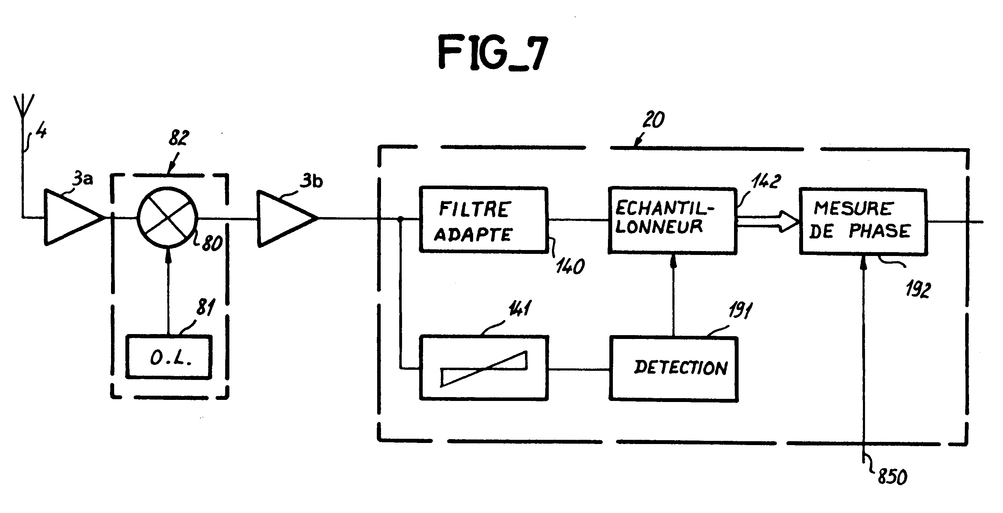

Sur la figure 7, on peut voir un dispositif 20 permettant de mesurer successivement la phase des divers échantillons de signal.

Le dispositif 20 comporte connectés en série un filtre adapté 140, un échantillonneur numérique 142 et un dispositif de mesure de phase 192. Un filtre impair 141 est connecté à l'entrée du filtre adapté 140. La sortie du filtre impair 141 est connecté à l'entrée d'un dispositif de détection de passage à 0 191. Le dispositif de détection de passage à 0 191 commande le dispositif d'échantillonnage 142. Le dispositif de détection 191 est par exemple un trigger de Schmitt.

Le dispositif de mesure de phase 192 est par exemple un comparateur de phase comparant la phase du signal reçu avec une phase de référence reçue par une ligne 850.

Dans une variante de réalisation analogique du dispositif selon l'invention les filtres adaptés 140 et les filtres impairs 141 sont par exemple réalisés sous forme du dispositif à ondes acoustiques de surface.

Dans une seconde variante de réalisation du dispositif selon l'invention les filtres adaptés 140 et les filtres impairs 141 sont des filtres numériques.

Dans l'exemple illustré sur la figure 7 le dispositif selon l'invention est connecté à un dispositif de réception d'ondes modulées en phase. Les ondes modulées en phase transmettent par exemple les émissions de télévision, des émissions radiophoniques, des instructions de commande ou des données alphanumériques. Dans un exemple illustré sur la figure 7 le dispositif de réception comporte connectés en série une antenne de réception 4, un amplificateur hyperfréquence 3a, un dispositif de réduction de frequence 82, un amplificateur fréquence intermédiaire 3b. Le dispositif de réduction de fréquence 82 comporte par exemple un duplexeur 80 raccordé d'une part à l'amplificateur hyperfréquence 3a et d'autre part à un oscillateur local 81.

Dans une variante simplifiée de réalisation du dispositif selon l'invention le dispositif de détection 191 commande directement le dispositif de mesure de phase 192.

Lors du passage par 0 du signal ayant traverse le filtre impair 141 le dispositif de détection envoi un signal de commande permettant l'échantillonnage du signal. Le passage par 0 du signal correspond au point 199 de la figure 6 et donc au point 197 des figures 4 et 5. Lors de la réalisation du dispositif 20 selon l'invention on prend bien soin que les retards induits dans la branche comportant le filtre adapté 140 et l'échantillonneur 142 soient compensés par le retard induit dans la branche comportant le filtre impair 141 et le dispositif de détection 191.

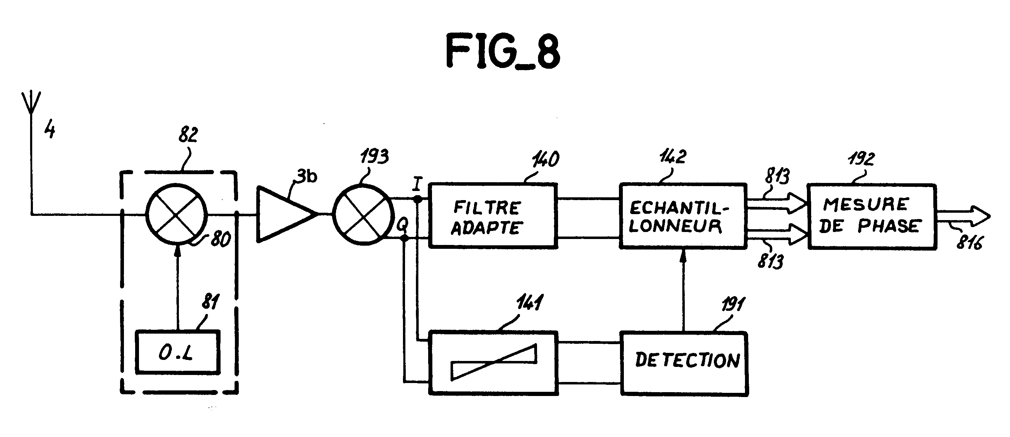

Sur la figure 8, on peut voir un exemple de réalisation du dispositif selon l'invention assurant la séparation de la partie réelle et imaginaire du signal, c'est-à-dire la partie en phase et en quadrature de phase, et effectuant les traitements séparés sur les deux parties du signal jusqu'à la mesure de phase.

La séparation du signal en sa partie réelle et imaginaire permet de simplifier la mesure de phase. En effet la valeur de la partie réelle est proportionnelle au cosinus de la phase, tandis que, la valeur de la partie imaginaire est proportionnelle au sinus. Ainsi de la comparaison de la partie imaginaire et de la partie réelle on peut déduire de façon simple et biunivoque la phase du signal.

Dans le cas où la précision exigée, c'est-à-dire le nombre de bits d'adresse nécessaire, le permet, on tabule la conversion des valeurs de la partie réelle et de la partie imaginaire du signal à phase. Dans ce cas, le dispositif de mesure de phase 192 est une mémoire permanente. Les valeurs I et Q du signal sont connectées sur le bus d'adresse 813, la valeur de la phase est recueillie sur le bus de donnée 816. Pour des productions de grande série on utilisera avantageusement une mémoire morte (ROM en terminologe anglo-saxonne). Pour des séries plus faibles on utilisera des mémoires mortes programmables (PROM en terminologie anglo – saxonne), de mémoires mortes effaçables (EPROM en terminologie anglo – saxonne) ou de mémoires mortes électriquement effaçables et (EPROM en terminologie anglo – saxonne). Dans la mesure où l'on veut se réserver la possibilité de modifier les données de la table contenue dans la mémoire il est possible d'utiliser des mémoires vives (RAM en terminologie anglo – saxonne). Les valeurs de la table sont stockées chaque fois qu'on le désire par exemple à partir d'un disque magnétique.

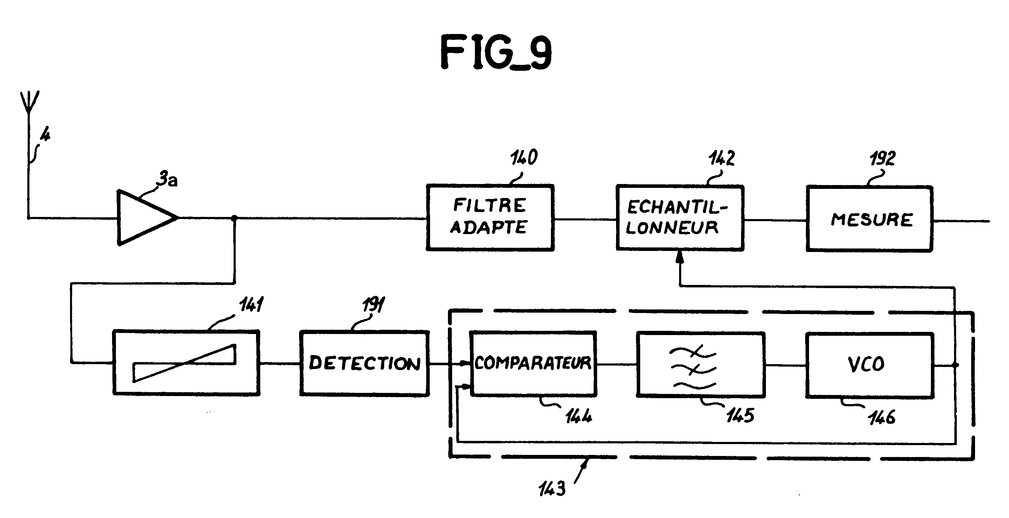

Sur la figure 9, on peut voir une variante de réalisation du dispositif selon l'invention comportant une boucle de verrouillage de phase (PLL en ter – minologie anglo – saxonne). Le dispositif de ver – rouillage de phase 143 est connecté entre le dis – positif de détection 191 et l'échantillonneur 142. Le dispositif de verrouillage de phase comporte, par exemple, connectés en série un comparateur de phase 144, un filtre passe – bas 145 et un oscilla – teur commandable en tension 146 (VCO en termi – nologie anglo – saxonne). La sortie de l'oscillateur commandable en tension 146 est connectée d'une part au dispositif d'échantillonnage 142 et d'autre part à une seconde entrée du comparateur 144.

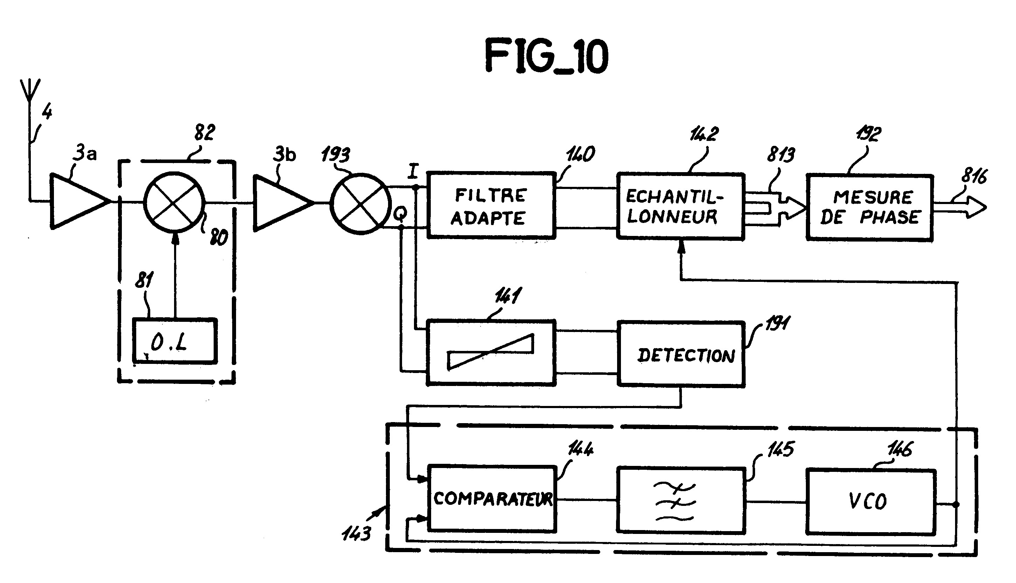

Sur la figure 10, on peut voir un exemple de réalisation du dispositif selon l'invention associant le principe de la séparation du signal en partie réelle et imaginaire et l'utilisation d'un circuit 143 de verrouillage de phase. Le dispositif selon cette réalisation de l'invention comporte connectés en série une antenne de réception 4, un amplificateur hyperfréquence 3a, un dispositif de réduction de fréquence 82, un amplificateur fréquence intermé – diaire 3b, un dispositif 193 de séparation de la composante réelle et imaginaire du signal, un filtre adapté 140, un échantillonneur 142, un bus d'adresse 813, un dispositif de mesure de phase 192 et un bus de donnée 816. D'autre part, à la sortie du dispositif de séparation de la partie réelle et imaginaire du signal 193 sont connectés en série un filtre impair 141, un dispositif de détection 191 et un dispositif de verrouillage de phase 143. Le dispositif de verrouillage de phase 143 comporte par exemple un comparateur 144 connecté à un filtre passe – bas 145 et à un oscillateur comman – dable en tension 146.

Le filtre adapté 140, le filtre impair 141, l'échantillonneur 142 ainsi que le dispositif de dé – tection 191 traitent simultanément les composantes imaginaires et réelles du signal. Le dispositif de détection 191 est connecté à une première entrée du comparateur 144. La sortie de l'oscillateur commandable en tension 146 est connectée d'une part au dispositif de commande de l'échantillon – neur 142 et d'autre part à une seconde entrée du comparateur 144.

La présente invention s'applique principale – ment à la détection, à la démodulation et au dé – codage de phase.

La présente invention s'applique notamment à la réception d'émission des télévisions, d'émissions radiophoniques ou des transmissions des données transmises en modulation de phase ou en modu – lation de phase et d'amplitude.

La présente invention s'applique aussi au dis – positif radar.

## Revendications

1. Dispositif de mesure de phase susceptible de mesurer la phase d'un signal en sortie d'un filtre adapté (140), caractérisé en ce qu'il comporte :
   – un filtre (141) dont l'entrée est connectée en parallèle à l'entrée du filtre adapté, ledit filtre étant impair, c'est – à – dire ayant une fonction de transfert symétri – que en amplitude et antisymétrique en phase par rapport à la fréquence centrale dudit filtre ;
   – un détecteur (191) de passage à 0 du signal issu du filtre impair ; et
   – des moyens de mesure de phase (142, 192) commandés par ledit detecteur (191) et effectuant une comparaison de la phase du signal issu du filtre adapté (140) avec une phase de référence.

2. Dispositif de mesure de phase selon la re – vendication 1, caractérisé en ce que le filtre impair (141) est un filtre à ondes acoustiques de surface.

3. Dispositif de mesure de phase selon la re – vendication 1, caractérisé en ce que le filtre impair (141) est numérique.

4. Dispositif de mesure de phase selon l'une quelconque des revendications précédentes, caractérisé en ce que le détecteur (191) de passage à 0 du signal issu du filtre impair (141) est un trigger de Schmitt.

5. Dispositif de mesure de phase selon l'une quelconque des revendications précédentes, caractérisé en ce qu'il comporte un dispositif à verrouillage de phase (143) connecté à la sortie du détecteur (191) de passage à 0.

6. Dispositif de mesure de phase selon l'une quelconque des revendications précédentes, caractérisé en ce que les moyens de mesure de phase (142, 192) comportent un échantil –

lonneur (142) du signal issu du filtre adapté (140), cet échantillonneur étant commandé par le détecteur (191) de passage à 0, et délivrant des échantillons' à un dispositif de comparaison (192) de phase.

7. Dispositif de mesure de phase selon l'une quelconque des revendications précédentes, caractérisé en ce qu'il comporte un dispositif (193) susceptible de séparer la partie réelle et la partie imaginaire du signal en entrée du filtre adapté (140), le filtre impair (141), et le détecteur (191) de passage à 0, traitant séparément les deux parties de ce signal.

8. Dispositif de mesure de phase selon la revendication 7, caractérisé en ce que le dispositif de comparaison (192) de phase compare la valeur de ladite partie réelle à la valeur de ladite partie imaginaire, l'une ou l'autre étant prise comme référence de phase.

9. Dispositif de mesure de phase selon la revendication 8, caractérisé en ce que le dispositif de comparaison (192) de phase est une mémoire permanente, les valeurs des parties réelles et imaginaires du signal étant appliquées à un bus d'adresses (813), la valeur de phase correspondante, tabulée dans ladite mémoire étant émise sur un bus de données (816).

10. Dispositif de mesure de phase selon l'une quelconque des revendications précédentes, caractérisé en ce qu'il comporte un dispositif (82) susceptible de réduire la fréquence du signal d'entrée du filtre adapté (140).

11. Procédé de mesure de la phase d'un signal d'entrée comportant plusieurs échantillons (194), et subissant un filtrage adapté, le procédé étant caractérisé en ce que l'on détermine l'instant de mesure de la phase et/ou d'échantillonnage en détectant le passage à 0 du signal d'entrée ayant subi un filtrage impair selon une fonction de transfert antisymétrique en phase et symétrique en amplitude par rapport à la fréquence centrale du filtrage impair, et en ce que l'on compare, à cet instant, la phase du signal d'entrée après filtrage adapté avec une phase de référence.

**Claims**

1. Phase measuring device capable of measuring the phase of a signal at the output of a matched filter (140), characterised in that it includes:

   – a filter (141) whose input is connected in parallel to the input of the matched filter, the said filter being odd, that is to say having a transfer function which is symmetric in amplitude and anti – symmetric in phase with respect to the central frequency of the said filter;
   – a detector (191) of 0 – crossing of the signal coming from the odd filter; and
   – phase measuring means (142, 192) controlled by the said detector (191) and carrying out a comparison of the phase of the signal coming from the matched filter (140) with a reference phase.

2. Phase measuring device according to Claim 1, characterised in that the odd filter (141) is a surface acoustic wave filter.

3. Phase measuring device according to Claim 1, characterised in that the odd filter (141) is digital.

4. Phase measuring device according to any one of the preceding claims, characterised in that the detector (191) of 0 – crossing of the signal coming from the odd filter (141) is a Schmitt trigger.

5. Phase measuring device according to any one of the preceding claims, characterised in that it comprises a phase locking device (143) connected to the output of the 0 – crossing detector (191).

6. Phase measuring device according to any one of the preceding claims, characterized in that the phase measuring means (142, 192) include a sampler (142) of the signal coming from the matched filter (140), this sampler being controlled by the 0 – crossing detector (191), and delivering samples to a phase comparison device (192).

7. Phase measuring device according to any one of the preceding claims, characterized in that it includes a device (193) capable of separating the real part and the imaginary part of the signal at the input of the adapted filter (140), the odd filter (141), and the 0 – crossing detector (191), separately processing the two parts of this signal.

8. Phase measuring device according to Claim 7, characterized in that the phase comparison device (192) compares the value of the said real part to the value of the said imaginary part, one or the other being taken as phase reference.

9. Phase measuring device according to Claim 8, characterized in that the phase comparison device (192) is a permanent memory, the values of the real and imaginary parts of the signal being applied to an address bus (813), the corresponding phase value, tabulated in the said memory, being sent onto a data bus (816).

10. Phase measuring device according to any one of the preceding claims, characterized in that it includes a device (82) capable of reducing the frequency of the input signal of the matched filter (140).

11. Method of measuring the phase of an input signal including several samples (194), and undergoing matched filtering, the method being characterized in that the instant for measuring the phase and/or for sampling is determined by detecting the 0-crossing of the input signal having undergone odd filtering according to a transfer function which is antisymmetric in phase and symmetric in amplitude with respect to the central frequency of the odd filtering, and in that, at this instant, the phase of the input signal after matched filtering is compared with a reference phase.

**Patentansprüche**

1. Phasenmeßvorrichtung zum Messen der Phase eines Signals am Ausgang eines angepaßten Filters (140), dadurch gekennzeichnet, daß sie enthält:
   - ein Filter (141), dessen Eingang parallel zum Eingang des angepaßten Filters angeschlossen ist, wobei dieses Filter ungerade ist, d. h. eine Übertragungsfunktion hat, die hinsichtlich der Amplitude symmetrisch und hinsichtlich der Phase antisymmetrisch bezüglich der Mittenfrequenz des Filters ist;
   - einen Nulldurchgangsdetektor (191) für das vom ungeraden Filter abgegebene Signal; und
   - Phasenmeßmittel (142, 192), die von dem Detektor (191) gesteuert sind und einen Vergleich der Phase des von dem angepaßten Filter (140) abgegebenen Signals mit einer Referenzphase durchführen.

2. Phasenmeßvorrichtung nach Anspruch 1, dadurch gekennzeichnet, daß das ungerade Filter (141) ein Filter für akustische Oberflächenwellen ist.

3. Phasenmeßvorrichtung nach Anspruch 1, dadurch gekennzeichnet, daß das ungerade Filter (141) ein digitales Filter ist.

4. Phasenmeßvorrichtung nach einem der vorhergehenden Ansprüche, dadurch gekennzeichnet, daß der Nulldurchgangsdetektor (191) des von dem ungeraden Filter (141) abgegebenen Signals ein Schmitt-Trigger ist.

5. Phasenmeßvorrichtung nach einem der vorhergehenden Ansprüche, dadurch gekennzeichnet, daß sie eine Phasenverriegelungsvorrichtung (143) enthält, die an den Ausgang des Nulldurchgangsdetektors (191) angeschlossen ist.

6. Phasenmeßvorrichtung nach einem der vorhergehenden Ansprüche, dadurch gekennzeichnet, daß die Phasenmeßmittel (142, 192) einen Abtaster (142) für das vom angepaßten Filter (140) abgegebene Signal enthalten, wobei dieser Abtaster von dem Nulldurchgangsdetektor (191) gesteuert ist und Abtastwerte an eine Phasenvergleichsvorrichtung (192) abgibt.

7. Phasenmeßvorrichtung nach einem der vorhergehenden Ansprüche, dadurch gekennzeichnet, daß sie eine Vorrichtung (193) zum Trennen des Realteils und des Imaginärteils des Eingangssignals des angepaßten Filters (140) enthält, wobei das ungerade Filter (141) und der Nulldurchgangsdetektor (191) die zwei Teile dieses Signals getrennt behandeln.

8. Phasenmeßvorrichtung nach Anspruch 7, dadurch gekennzeichnet, daß die Phasenvergleichsvorrichtung (192) den Wert des Realteils mit dem Wert des Imaginärteils vergleicht, wobei entweder der eine oder der andere Wert als Phasenreferenz genommen wird.

9. Phasenmeßvorrichtung nach Anspruch 8, dadurch gekennzeichnet, daß die Phasenvergleichsvorrichtung (192) ein Festspeicher ist, daß die Werte der Realteile und der Imaginärteile des Signals an einen Adreßbus (813) angelegt werden und daß der entsprechende Phasenwert, der in dem Speicher tabelliert ist, über einen Datenbus (816) ausgegeben wird.

10. Phasenmeßvorrichtung nach einem der vorhergehenden Ansprüche, dadurch gekennzeichnet, daß sie eine Vorrichtung (82) enthält, die die Frequenz des Eingangssignals des angepaßten Filters (140) reduzieren kann.

**11.** Verfahren zum Messen der Phase eines Eingangssignals, das mehrere Abtastwerte (194) aufweist und eine angepaßte Filterung erfährt, wobei das Verfahren dadurch gekennzeichnet ist, daß der Zeitpunkt der Phasenmessung und/oder der Abtastung bestimmt wird, indem der Nulldurchgang des Eingangssignals festgestellt wird, das eine ungerade Filterung entsprechend einer Übertragungsfunktion erfahren hat, die hinsichtlich der Phase antisymmetrisch und hinsichtlich der Amplitude symmetrisch bezüglich der Mittenfrequenz der ungeraden Filterung ist, und daß an diesem Zeitpunkt die Phase des Eingangssignals nach der angepaßten Filterung mit einer Referenzphase verglichen wird.

FIG_1

FIG_2

FIG_3

FIG_4

FIG_5

FIG_6

# FIG_7

4

3a

82

80

81

O.L.

3b

20

FILTRE ADAPTE
140

ECHANTIL-LONNEUR
142

MESURE DE PHASE
192

141

191

DETECTION

850

EP 0 286 664 B1

# FIG_8

EP 0 286 664 B1

# FIG_9

# FIG_10

EP 0 286 664 B1